# EUROPÄISCHE PATENTSCHRIFT

(11) **EP 0 689 718 B1**
(45) Veröffentlichungstag und Bekanntmachung des Hinweises auf die Patenterteilung: **07.10.1998**
(21) Anmeldenummer: 94908956.9
(22) Anmeldetag: 12.03.1994
(51) Int. Cl.: H01L 21/306, H01L 23/52

(54) **ÄTZVERFAHREN UND VORRICHTUNG ZUR REINIGUNG VON HALBLEITERELEMENTEN, INSBESONDERE LEISTUNGSDIODEN**
ETCHING PROCESS AND DEVICE FOR CLEANING SEMICONDUCTOR COMPONENTS, IN PARTICULAR POWER DIODES
PROCEDE D'ATTAQUE CHIMIQUE ET DISPOSITIF POUR LE NETTOYAGE D'ELEMENTS SEMI-CONDUCTEURS, EN PARTICULIER DE DIODES DE PUISSANCE

(30) Priorität: 20.03.1993 DE 4308990
(43) Veröffentlichungstag der Anmeldung: 03.01.1996
(73) Patentinhaber: ROBERT BOSCH GMBH, 70442 Stuttgart (DE)
(72) Erfinder: BARTH, Stephan-Manuel, D-82194 Groebenzell (DE)
(86) Internationale Anmeldenummer: DE9400246
(87) Internationale Veröffentlichungsnummer: WO9422165

(56) Entgegenhaltungen:
- US-A- 4 341 594
- PATENT ABSTRACTS OF JAPAN vol. 6, no. 200 (E-135)9. Oktober 1982 & JP,A,57 111 055 (SHIN NIPPON DENKI KK) 10. Juli 1982
- IBM TECHNICAL DISCLOSURE BULLETIN. Bd. 32, Nr. 6A , November 1989 , NEW YORK US Seiten 362 - 362 'RIE DAMAGE REMOVAL IN A DOWNSTREAM PLASMA REACTOR'

## Beschreibung

### STAND DER TECHNIK

Die Erfindung betrifft ein Plasmaätzverfahren zur Reinigung seitlich freiliegender pn-Übergänge von Halbleiterelementen, insbesondere Leistungsdioden, nach dem Versehen des entsprechenden Halbleiterchips mit Anschlußelementen durch Zusammenlöten, sowie eine Vorrichtung zur Durchführung des Verfahrens.

Bei der Fertigung beispielsweise von Leistungsdioden erfolgt herkömmlicherweise nach dem Zusammenlöten von Kühlsockel, Diodenchip und Kopfdraht eine Reinigung durch Siliziumabtrag der bis dahin noch seitlich freiliegenden pn-Übergänge des Diodenchips mittels einen naßchemischen alkalischen Ätzverfahrens, z.B. mittels KOH-Lauge, um die Sperrfähigkeit der pn-Übergänge auszubilden. Dieses bekannte Verfahren hat den Nachteil, daß der seitliche Siliziumabtrag dotierungs- und kristallorientierungsabhängig erfolgt, so daß die entstehenden Ätzkonturen in den verschiedenen Dotierungsbereichen stark unterschiedlich ausgeprägt sind. Außerdem können Kapillareffekte abhängig von der Form der Anschlußelemente auftreten. Weiterhin besteht eine Anfälligkeit gegenüber externer Kontaminierung der Ätzlösung und eine Konzentrations-, Temperatur- und Agitationsabhängigkeit sowie eine Abhängigkeit von ätzsystemspezifischen elektrochemischen Potentialdifferenzen. Darüber hinaus ist dieses naßchemische Ätzverfahren durch die erforderlichen zahlreichen Spülprozesse sehr aufwendig. Diese Nachteile führen insgesamt bei der Massenproduktion immer wieder zu erheblichen Ausbeuteeinbußen, wobei sich die Ursachenfindung durch die Vielzahl der beteiligten Mechanismen sehr diffizil gestaltet.

Plasma-Ätzverfahren sind zwar in der Halbleitertechnik bekannt, sie werden jedoch fast ausschließlich bei der Wafer-Herstellung eingesetzt.

Aus der Entgegenhaltung JP 57-111055 ist ein Ätzverfahren zur Reinigung freiliegender PN-Übergänge von Halbleiterelementen bekannt, bei dem die Halbleiterelemente nach dem Versehen mit Anschlußelementen mit einem Plasmaätzverfahren nachbehandelt werden (siehe Patent Abstracts of Japan).

Die Entgegenhaltung IBM Technical Disclosure Bulletin, Vol. 32, No. 6A, Nov. 1989, S. 362-363 beschreibt einen Plasmaätzreaktor und ein Verfahren zum Plasmaätzen, bei dem ein Halbleiterwafer mit seiner zu ätzenden Oberfläche senkrecht zum Plasmastrom angeordnet ist.

Eine Aufgabe der vorliegenden Erfindung ist es, ein Ätzverfahren der eingangs erwähnten Art und eine Vorrichtung zu dessen Durchführung zu schaffen, mit dem verbesserte Ätzkonturen unabhängig vom Dotierungsprofil der seitlich freiliegenden Halbleiterchips erzielt werden können.

### VORTEILE DER ERFINDUNG

Das erfindungsgemäße Plasma-Ätzverfahren mit den kennzeichnenden Merkmalen des Hauptanspruchs hat zur Reinigung der seitlich freiliegenden pn-Übergänge von Halbleiterelementen gegenüber dem naßchemischen alkalischen Ätzverfahren den Vorteil, daß die erreichbaren Ätzkonturen am Einzelbauteil denen beim Naßätzen weit überlegen sind, wobei insbesondere die Chipkante beim Plasma-Ätzen nahezu vertikal ausgebildet wird.

Dieser Vorteil des Plasma-Ätzverfahrens ermöglicht es, auch Dioden mit sehr flachliegenden, d.h. nahe den Anschlußelementen gelegenen, pn-Übergängen, die beim Naßätzen sehr ungünstig erfaßt werden, zu behandeln. Typische Tiefen sind hierbei 10-20 µm. Diese Vorteile haben ihren Grund vor allem darin, daß das Plasma-Ätzverfahren weitgehend orierentierungs- und dotierungsunabhängig ist. Durch Wegfall der zahlreichen Spülprozesse eignet sich das Plasma-Ätzverfahren insbesondere für die Massenherstellung, wobei die Ausbeute gegenüber dem naßchemischen Ätzverfahren bei geeigneter Prozeßparameterwahl sogar erhöht werden kann.

Durch die in den Unteransprüchen 2 bis 9 aufgeführten Maßnahmen sind vorteilhafte Weiterbildungen und Verbesserungen des im Anspruch 1 angegebenen Plasmaätzverfahrens möglich. Eine vorteilhafte Durchführung des Verfahrens wird durch die in den Ansprüchen 10 bis 13 angegebene Vorrichtung ermöglicht.

Als Ätzgase werden zweckmäßigerweise Stickstoff-, Schwefel- oder Kohlenstoffluoride verwendet, insbesondere CF₄, SF₆ oder NF₃.

Eine vorteilhafte Durchführung des Ätzverfahrens besteht darin, daß das durch Einkopplung hochfrequenter elektromagnetischer Wellen, insbesondere Mikrowellen, ionisierte Ätzgas in einem Plasma-Reaktionsbehälter den zu reinigenden Halbleiterelementen zugeführt wird. Dabei strömt das Ätzgas bei einem Druck von vorzugsweise 0,1-10 mbar durch den Plasma-Reaktionsbehälter.

Um den thermisch aktivierten Ätzvorgang möglichst schnell und optimal durchzuführen, werden die Halbleiterelemente zweckmäßigerweise auf eine Temperatur unterhalb des Schmelzpunkts des Lots nahe diesem Schmelzpunkt aufgeheizt. Um möglichst nahe und exakt diese Temperatur einstellen zu können, erweist sich eine Temperaturregelung als besonders günstig. Zur Aufheizung werden dabei die Halbleiterelemente der gezeigten Form mit ihren Kühlsockeln auf eine Heizvorrichtung, insbesondere Heizplatte, gelegt.

Noch bessere Ergebnisse beim Ätzvorgang werden dadurch erreicht, daß dem Ätzgas ein sauerstoffhaltiges Gas, z.B. O₂ oder N₂O zugesetzt wird. Das Zusatzgas ermöglicht es, in bestimmten Fällen eine Maximierung der Ätzrate unter gleichzeitiger Minimierung einer ätzgasspezifischen Schichtabscheidung vorzunehmen.

Bei sehr hochsperrenden Dioden können ätzgasspezifische Verunreinigungen des erfindungsgemäßen Plasma-Ätzverfahrens bewirken, daß die Sperrkennlinien der Dioden eine nicht ausreichende Qualität besitzen und z.B. Instabilitäten aufweisen. Um in diesem Falle optimale Ergebnisse zu erreichen, wird zweckmäßigerweise eine naßchemische oder plasmachemische Nachbehandlung durchgeführt. Die naßchemische Nachbehandlung erfolgt bevorzugt mittels einer verdünnten Lauge (z.B. KOH) oder deionisiertem Wasser. Wird eine plasmachemische Nachbehandlung bevorzugt, so wird diese mittels eines O₂⁻ oder H₂⁻ oder N₂-haltigen Plasmas durchgeführt. Auch bringt ein Tempern der geätzten Teile in einer Inertgas-Atmosphäre (z.B. N₂-Gas) Vorteile für das Sperrvermögen. Diese Nachbehandlung wird im Vergleich zum erfindungsgemäßen Ätzprozeß nur so kurzfristig angewandt, daß der ätzprofilbestimmende Prozeß des Plasma-Ätzens mittels Fluorverbindungen bleibt.

Eine vorteilhafte Vorrichtung zur Durchführung des erfindungsgemäßen Ätzverfahrens besteht darin, daß ein mit einer Pumpe verbundener Plasma-Reaktionsbehälter sowie eine Einrichtung zur Erzeugung eines Plasmas aus einer gasförmigen Fluorverbindung als Ätzgase vorgesehen ist, wobei eine die zu behandelnden Halbleiterelemente aufnehmende, mit Durchgangslöchern versehene Heizeinrichtung im Plasma-Reaktionsbehälter angeordnet ist. Die Einrichtung zur Erzeugung des Plasmas ist zweckmäßigerweise dem Plasma- Reaktionsbehälter strömungsmäßig vorgeschaltet und weisen eine Zuführungsleitung für die gasförmige Fluorverbindung auf.

Die Heizeinrichtung zum Aufheizen der Halbleiterelemente besteht zweckmäßigerweise aus wenigstens einer Heizplatte. Damit verbunden ist eine Temperaturregelvorrichtung.

Ein Ausführungsbeispiel einer Vorrichtung zur Durchführung des erfindungsgemäßen Ätzverfahrens ist in der Zeichnung dargestellt und in der nachfolgenden Beschreibung näher erläutert. Es zeigen:
- Fig. 1: eine schematische Darstellung eines Plasma-Reaktionsbehälters und
- Fig. 2: in einer Teildarstellung einen Randbereich des Halbleiterchips vor und nach dem Ätzen.

### BESCHREIBUNG DES PLASMA-ÄTZVERFAHRENS ANHAND DES AUSFÜHRUNGSBEISPIELS

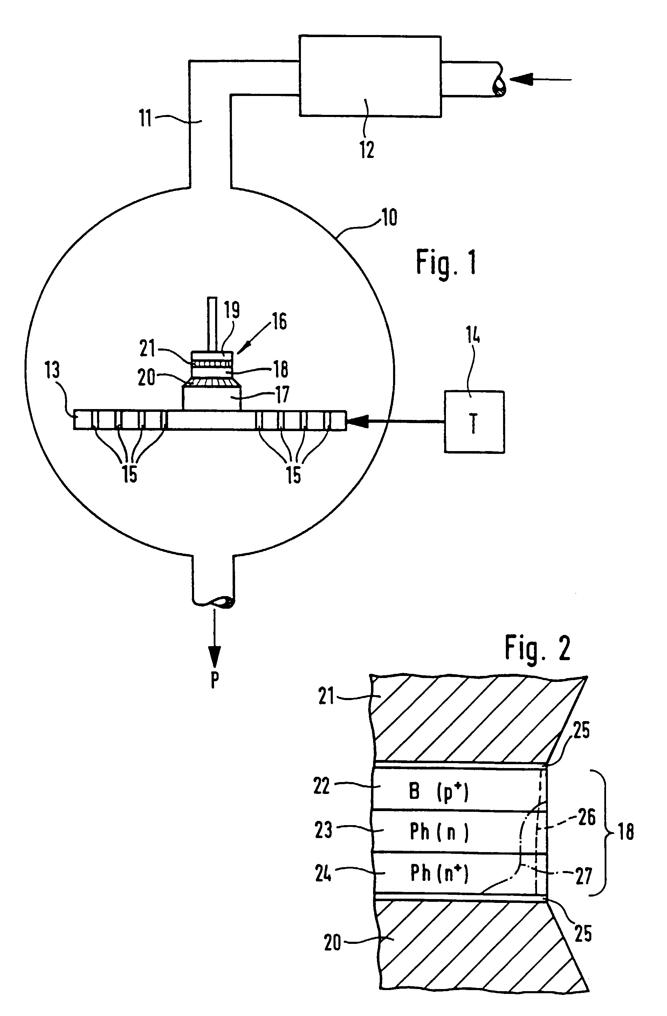

Die in Fig. 1 dargestellte Plasma-Ätzvorrichtung besteht im wesentlichen aus einem Plasma-Reaktionsbehälter 10, dem über eine Leitung 11 in einem Plasma-Generator 12 erzeugtes Plasma zugeführt wird. Dem Plasma-Generator 12 wird zunächst eine gasförmige Fluorverbindung als Ausgangsstoff für das Plasma zugeführt. Hierbei handelt es sich beispielsweise um ein Stickstoff-, Schwefel- oder Kohlenstofffluorid, wie Stickstofftrifluorid (NF₃), Schwefelhexafluorid (SF₆) oder Kohlenstofftetrafluorid (CF₄). Einem solchen Ätzgas wird noch ein sauerstoffhaltiges Gas wie O₂ oder N₂O o.dgl. zugesetzt, um in bestimmten Fällen eine Maximierung der Ätzrate unter gleichzeitiger Minimierung einer ätzgasspezifischen Schichtabscheidung vorzunehmen. In anderen Fällen kann dieses zusätzliche Gas auch entfallen.

Der Plasma-Generator 12 erzeugt hochfrequente elektromagnetische Wellen, wie Mikrowellen, die durch Einkopplung das durchgeführte Ätzgas ionisieren. Die entstehenden Radikale und Ionen können mit Festkörpern chemische und physikalische Wechselwirkungen eingehen. Diese Vorgänge spielen sich bei einem Druck von typischerweise 1 mbar ab, wobei auch ein Druck zwischen 0,1-10 mbar in Einzelfällen möglich ist. Den Durchsatz des ionisierten Ätzgases durch den Reaktionsbehälter 10 erfolgt mittels einer nicht dargestellten Pumpe P.

Wegen der angestrebten Gleichmäßigkeit der Ätzkontur ist bei der Konstruktion des Plasma-Generators 12 zu beachten, daß störende anisotrope physikalische Wechselwirkungen, z.B. Stoßprozesse, ausgeschlossen werden.

Im Reaktionsbehälter 10 ist eine Heizplatte 13 angeordnet, die mittels einer Temperaturregelvorrichtung 14 auf eine gewünschte Temperatur gebracht wird. Diese Temperatur liegt unterhalb des Schmelzpunktes derjenigen Komponente eines zu behandelnden montierten Halbleiterelements, die den geringsten Schmelzpunkt aufweist. Diese Komponente ist im allgemeinen das verwendete Lot. Die Heizplatte 13 weist parallel zur Strömung des Ätzgases verlaufende Kanäle 15 auf, um die Strömung zu verbessern. Zur Vereinfachung wurde nur eine einzige Heizplatte 13 dargestellt, jedoch kann selbstverständlich auch eine größere Zahl von Heizplatten im Reaktionsbehälter 10 vorgesehen sein.

Auf die Heizplatte 13 werden nun die montierten bzw. fertig gelöteten Halbleiterelemente aufgelegt. Beim dargestellten Ausführungsbeispiel handelt es sich dabei um eine Leistungsdiode 16, die zur Veranschaulichung vergrößert dargestellt ist. In der praktischen Anwendung ist eine Vielzahl von derartigen Halbleiterelementen bzw. Leistungsdioden auf der Heizplatte 13 bzw. den Heizplatten angeordnet, und diese werden gemeinsam dem Plasma-Ätzverfahren unterzogen.

Die dargestellte Leistungsdiode 16 besteht aus einem Kühlsockel 17, einem Diodenchip 18 und einem Kopfdrahtanschluß 19. Diese drei Elemente sind über Lotschichten 20, 21 miteinander verbunden. Die Leistungsdiode 16 liegt dabei mit ihrem Kühl sockel 17 auf der Heizplatte 13 auf, um eine schnelle und sichere Aufheizung zu gewährleisten.

Wie in Fig. 2 vergrößert dargestellt ist, besteht der Diodenchip 18 aus drei Schichten, nämlich einer Bor-(P⁺)dotierten Schicht 22, einer Phosphor-(n)dotierten Schicht 23 und einer Phosphor-(n⁺)dotierten Schicht 24. Um das Anlöten des Diodenchips 18 zu ermöglichen, ist dieser an seinen Flachseiten mit einer Nickelschicht 25 versehen. Nach dem Zusammenlöten der Leistungsdiode 16 ist eine Reinigung der bis dahin noch seitlich freiliegenden pn-Übergänge durch Siliziumabtrag erforderlich, um die Sperrfähigkeit der pn-Übergänge auszubilden. Diese Reinigung bzw. der Siliziumabtrag erfolgt mittels des erfindungsgemäßen Plasma-Ätzverfahrens. Bei der Anwendung dieses Plasma-Ätzverfahrens ist aus Gründen der Isotropie und Homogenität nur die chemische Wechselwirkung der im Plasma enthaltenen Radikale und Ionen mit dem Diodenchip 18 von Interesse. Bekannte kommerzielle Plasma-Ätzanlagen, die nach dem Downstream-Prinzip arbeiten, können jegliche störende physikalische Wechselwirkungen ausschließen. Die Voraussetzung hierfür ist der Einsatz der Mikrowellenanregung durch den Plasma-Generator 12. Hierbei werden langlebige Ätzradikale mit Lebensdauern von bis zu größenordnungsmäßig 1 Sekunde gebildet.

Ein wichtiger Faktor beim Ätzen ist die Temperatur, da der Ätzvorgang ein thermisch aktivierter Prozeß ist. Die Aufheizung des Diodenchips 18 erfolgt - wie bereits beschrieben - über die Heizplatte 13 und den darauf angeordneten Kühlsockel 17 der Leistungsdiode 16. Die Gasdurchflüsse des Ätzgases sind entsprechend den Beladungsmengen von Leistungsdioden 16 bzw. anderen Halbleiterelementen zu wählen.

Durch den beschriebenen Plasma-Ätzprozeß kann eine Ätzkontur erreicht werden, wie sie durch eine gestrichelte Linie 26 dargestellt ist. Die Chipkante ist nach dem Plasma-Ätzen nahezu vertikal ausgebildet, während das beim bekannten Naßätzen auftretende Naßätzprofil charakteristische Spuren der Orientierungs- und Dotierungsabhängigkeit trägt. Das Naßätzprofil ist durch eine strichpunktierte Linie 27 dargestellt.

Bei sehr hochsperrenden Dioden können ätzgasspezifische Verunreinigungen des geschilderten Plasma-Ätzverfahrens bewirken, daß die Sperrkennlinien der Dioden eine nicht ausreichende Qualität besitzen und z.B. Instabilitäten aufweisen. Um dies zu verhindern, kann eine naßchemische Nachbehandlung in verdünnter Lauge (z.B. KOH) oder deionisiertem Wasser durchgeführt werden. Dieser Prozeß wird im Vergleich zum konventionellen Naßätzprozeß nur so kurzfristig angewandt, daß der ätzprofilbestimmende Prozeß des Plasma-Ätzens bleibt, das heißt, daß das Ätzprofil 26 erhalten bleibt.

Alternativ hierzu kann auch eine plasmachemische Nachbehandlung in einem O₂-, N₂- oder H₂-haltigen Plasma durchgeführt werden.

Obwohl das erfindungsgemäße Ätzverfahren für eine spezielle Art von Halbleiterdioden mit charakteristischem Halbleiterchip und besonderen Anschlußelementen dargestellt wurde, ist die Erfindung selbstverständlich nicht auf diese spezielle Ausführung mit Kopfdraht beschränkt.

## Patentansprüche

1. Plasmaätzverfahren zur Reinigung seitlich freiliegender pn-Übergänge von Halbleiterelementen (16) welche einen Halbleiterchip (18) aufweisen, der über eine jeweilige Lotschicht (20, 21) mit einem ersten und einem zweiten Anschlußelement (17, 19) verbunden wird und der einen seitlich freiliegenden pn-Übergang aufweist, wobei das erste Anschlußelement als Kühlsockel (17) ausgebildet wird, wobei
- in einem Plasma-Reaktionsbehälter (10) durch einen Einlaß das Plasma eines Ätzgases zugeführt wird und über einen dem Einlaß gegenüberliegenden Auslaß das Plasma abgeführt wird, wobei der Einlaß und der Auslaß zusammen die Strömungsrichtung für das Plasma definieren,
- auf eine im Reaktionsbehälter (10) im wesentlichen senkrecht zur Strömungsrichtung angeordnete plattenförmige Heizeinrichtung (13) die Halbleiterelemente (16) auf dem ersten Anschlußelement (17) aufgestellt werden,
- wobei das Plasma seitlich vorbei an den freiliegenden pn-Übergängen durch im wesentlichen in Strömungsrichtung in der plattenförmigen Heizeinrichtung (13) angordnete Durchgangslöcher (15) strömt und
- wobei die Temperatur der Halbleiterelemente (16) auf einen Wert zwischen Raumtemperatur und dem Schmelzpunkt der Lotschicht (20,21) geregelt wird.

2. Plasmaätzverfahren nach Anspruch 1, dadurch gekennzeichnet, daß die Temperatur nahe dem Schmelzpunkt der Lotschicht (20,21) liegt.

3. Plasmaätzverfahren nach Anspruch 1 oder 2, dadurch gekennzeichnet, daß die Halbleiterelemente Leistungsdioden sind.

4. Plasmaätzverfahren nach einem der vorheregehenden Ansprüche, dadurch gekennzeichnet, daß das Ätzgas eine Fluorverbindung ist und dem Ätzgas ein Sauerstoffhaltiges Gas (z.B. O₂ oder N₂O) zugesetzt wird.

5. Plasmaätzverfahren nach einem der vorhergehenden Ansprüche, dadurch gekennzeichnet, daß eine thermische, naßchemische oder plasmachemische Nachbehandlung durchgeführt wird.

6. Plasmaätzverfahren nach Anspruch 5, dadurch gekennzeichnet, daß die naßchemische Nachbehandlung mittels einer verdünnten Lauge oder deionisiertem Wasser durchgeführt wird.

7. Plasmaätzverfahren nach Anspruch 5, dadurch gekennzeichnet, daß die plasmachemische Nachbehandlung in einem O₂-, H₂- oder N₂-hältigen Plasma durchgeführt wird.

8. Plasmaätzverfahren nach Anspruch 1, dadurch gekennzeichnet, daß das Plasma durch Einkopplung hochfrequenter elektromagnetischer Wellen erzeugt wird.

9. Plasmaätzverfahren nach Anspruch 8, dadurch gekennzeichnet, daß die hochfrequenten elektromagnetischen Wellen Mikrowellen sind.

10. Vorrichtung zum Plasmaätzen von Halbleiterelementen (16), welche einen Halbleiterchip (18) aufweisen, der über eine jeweilige Lotschicht (20, 21) mit einem ersten und einem zweiten Anschlußelement (17, 19) verbunden ist und der einen seitlich freiliegenden pn-Übergang aufweist, wobei das erste Anschlußelement als Kühlsockel (17) ausgebildet ist, mit:
einer Einrichtung (12) zur Erzeugung des Plasmas, einem Plasma-Reaktionsbehälter (10) mit einem Einlaß zum Zuführen des Plasmas und mit einem dem Einlaß gegenüberliegenden, mit einer Pumpe verbundenen Auslaß zum Abführen des Plasmas, welche zusammen die Strömungsrichtung für das Plasma definieren;
mindestens einer plattenförmigen Heizeinrichtung (13), welche im wesentlichen senkrecht zur Strömungsrichtung im Plasma-Reaktionsbehälter (10) angeordnet ist und zum Aufstellen der Halbleiterelemente (16) auf dem ersten Anschlußelement (17) ausgebildet ist;
wobei die plattenförmige Heizeinrichtung (13) im wesentlichen in Strömungsrichtung angeordnet Durchgangslöcher (15) aufweist, die derart angeordnet sind, so daß das Plasma seitlich vorbei an dem freiliegenden pn-Übergang strömt;
und einer mit der Heizeinrichtung verbundenen Temperaturregelvorrichtung (14) zum Regeln der Temperatur der Halbleiterelemente (16) auf eine Temperatur zwischen Raumtemperatur und den Schmelzpunkt der Lotschicht (20, 21).

11. Vorrichtung nach Anspruch 10, dadurch gekennzeichnet, daß die Halbleiterelemente Leistungsdioden sind.

12. Vorrichtung nach Anspruch 10 oder 11, dadurch gekennzeichnet, daß die Einrichtung (12) zur Erzeugung des Plasmas eine Zuführungsleitung für die gasförmige Fluorverbindung aufweist.

13. Vorrichtung nach einem der Ansprüche 10 bis 12, dadurch gekennzeichnet, daß die Einrichtung (12) zur Erzeugung des Plasmas als Mikrowellengenerator ausgebildet ist.

## Claims

1. Plasma etching process for cleaning laterally exposed p-n junctions of semiconductor elements (16) which have a semiconductor chip (18) which is connected via a respective soldering layer (20, 21) to a first and a second connection element (17, 19), and which has a laterally exposed p-n junction, the first connection element being constructed as a cold base (17), it being the case that
- the plasma of an etching gas is fed in a plasma reaction vessel (10) through an inlet, and the plasma is led off via an outlet opposite the inlet, the inlet and outlet together defining the flow direction of the plasma,
- the semiconductor elements (16) on the first connection element (17) are set up on a plate-shaped heating device (13) arranged in the reaction vessel (10) essentially at right angles to the flow direction,
- the plasma flowing laterally past the exposed p-n junctions through through-holes (15) arranged essentially in the flow direction in the plate-shaped heating device (13), and
- the temperature of the semiconductor elements (16) being controlled to a value between room temperature and the melting point of the soldering layer (20, 21).

2. Plasma etching process according to Claim 1, characterized in that the temperature is close to the melting point of the soldering layer (20, 21).

3. Plasma etching process according to Claim 1 or 2, characterized in that the semiconductor elements are

4. Plasma etching process according to any one of the preceding claims, characterized in that the etching gas is a fluorine compound and the etching gas is admixed with an oxygen-containing gas (e.g. O₂ or N₂O).

5. Plasma etching process according to any one of the preceding claims, characterized in that a thermal, wet-chemical or plasma-chemical aftertreatment is carried out.

6. Plasma etching process according to Claim 5, characterized in that the wet-chemical aftertreatment is carried out by means of a dilute alkali or deionized water.

7. Plasma etching process according to Claim 5, characterized in that the plasma-chemical aftertreatment is carried out in an O₂-, H₂- or N₂-containing plasma.

8. Plasma etching process according to Claim 7, characterized in that the plasma is generated by the injection of high-frequency electromagnetic waves.

9. Plasma etching process according to Claim 8, characterized in that the high-frequency electromagnetic waves are microwaves.

10. Apparatus for plasma etching of semiconductor elements (16) which have a semiconductor chip (18) which is connected via a respective soldering layer (20, 21) to a first and a second connection element (17, 19) and which has a laterally exposed p-n junction, the first connection element being constructed as a cold base (17), having:
a system (12) for generating the plasma, a plasma reaction vessel (10) with an inlet for feeding the plasma and with an outlet, opposite the inlet and connected to a pump, for leading off the plasma, which together define the flow direction for the plasma;
at least one plate-shaped heating device (13) which is arranged essentially at right angles to the flow direction in the plasma reaction vessel (10) and is constructed for setting up the semiconductor elements (16) on the first connection element (17);
the plate-shaped heating device (13) having through-holes (15) which are arranged essentially in the flow direction and are arranged in such a way that the plasma flows laterally past the exposed p-n junction;
and a temperature control device (14), connected to the heating device, for controlling the temperature of the semiconductor elements (16) to a temperature between room temperature and the melting point of the soldering layer (20, 21).

11. Apparatus according to Claim 10, characterized in that the semiconductor elements are power diodes.

12. Apparatus according to Claim 10 or 11, characterized in that the system (12) for generating the plasma has a feed line for the gaseous fluorine compound.

13. Apparatus according to one of Claims 10 to 12, characterized in that the system (12) for generating the plasma is constructed as a microwave generator.

## Revendications

1. Procédé d'attaque au plasma pour nettoyer des jonctions pn dégagées latéralement d'éléments semi-conducteurs (16), comportant une puce semi-conductrice (18) reliée par chaque fois une couche de brasure (20, 21) à un premier et à un second élément de branchement (17, 19) et ayant une jonction pn dégagée latéralement, le premier élément de branchement étant en forme de socle de refroidissement (17),
- un réacteur à plasma (10) recevant le plasma d'un gaz d'attaque et ce gaz étant évacué par une sortie de plasma en regard de l'entrée, l'entrée et la sortie définissant en combinaison la direction de circulation du plasma,
- une installation de chauffage (13) en forme de plaque, disposée d'une manière essentiellement perpendiculaire à la direction d'écoulement dans un réacteur (10), recevant les éléments semi-conducteurs (16) disposés sur le premier élément de branchement (17),
- le plasma passant latéralement à côté des jonctions pn libérées, à travers des orifices de passage (15) disposés essentiellement dans la direction d'écoulement dans l'installation de chauffage (13) en forme de plaque et,
- la température des éléments semi-conducteurs (16) est régulée à une valeur comprise entre la température ambiante et le point de fusion de la couche de brasure (20, 21).

2. Procédé selon la revendication 1,
caractérisé en ce que
la température est proche du point de fusion de la couche de brasure (20, 21).

3. Procédé selon la revendication 1 ou 2,
caractérisé en ce que
les éléments semi-conducteurs sont des diodes de puissance.

4. Procédé selon l'une des revendications précédentes,
caractérisé en ce que
le gaz d'attaque est une combinaison de fluor et le gaz d'attaque est un gaz contenant de l'oxygène (par exemple O₂ ou N₂O).

5. Procédé selon l'une quelconque des revendications précédentes,
caractérisé en ce qu'
on effectue un traitement de finition thermique, par voie chimique humide ou par plasma.

6. Procédé selon la revendication 5,
caractérisé en ce que
le traitement de finition par voie chimique humide est exécuté à l'aide d'une lessive diluée ou d'eau déionisée.

7. Procédé selon la revendication 5,
caractérisé en ce que
le traitement de finition au plasma se fait dans un plasma contenant O₂-, H₂- ou N₂.

8. Procédé selon la revendication 1,
caractérisé en ce que
le plasma est généré par l'injection d'ondes électromagnétiques à haute fréquence.

9. Procédé selon la revendication 8,
caractérisé en ce que
les ondes électromagnétiques à haute fréquence sont des micro-ondes.

10. Dispositif d'attaque au plasma d'éléments semi-conducteurs (16) comportant une puce semi-conductrice (18) reliée par une couche de brasure respective (20, 21) à un premier et à un second élément de branchement (17, 19), et ayant une jonction pn dégagée latéralement, le premier élément de branchement étant en forme de socle de refroidissement (17), comprenant :
- une installation (12) pour générer le plasma,
- un réacteur à plasma (10) avec une entrée pour l'alimentation du plasma et, en regard de celle-ci, une sortie reliée à une pompe pour évacuer le plasma, définissant en combinaison la direction d'écoulement du plasma,
- au moins une installation de chauffage (13) en forme de plaque disposée essentiellement perpendiculairement à la direction d'écoulement dans le réacteur à plasma (10) et réalisée pour placer les éléments semi-conducteurs (16) sur le premier élément de branchement (17),
- l'installation de chauffage en forme de plaque (13) ayant des orifices traversants (15) essentiellement dans la direction d'écoulement, ces orifices étant disposés de façon que le plasma s'écoule latéralement par rapport à la jonction pn, dégagée, et
- un dispositif de régulation de température (14) relié à l'installation de chauffage pour réguler la température des éléments semi-conducteurs (16) à une température comprise entre la température ambiante et le point de fusion de la couche de brasure (20, 21).

11. Dispositif selon la revendication 10,
caractérisé en ce que
les éléments semi-conducteurs sont des diodes de puissance.

12. Dispositif selon les revendications 10 ou 11,
caractérisé en ce que
l'installation (12) générant le plasma comporte une conduite d'alimentation pour la combinaison de fluor à l'état gazeux.

13. Dispositif selon l'une des revendications 10 à 12,
caractérisé en ce que
l'installation (12) générant le plasma est un générateur de micro-ondes.
